(19) **Europäisches Patentamt**
European Patent Office
Office européen des brevets

(11) **EP 4 004 567 B1**

(12) **EUROPÄISCHE PATENTSCHRIFT**

(45) Veröffentlichungstag und Bekanntmachung des Hinweises auf die Patenterteilung:
**16.08.2023   Patentblatt 2023/33**

(21) Anmeldenummer: **20743102.4**

(22) Anmeldetag: **15.07.2020**

(51) Internationale Patentklassifikation (IPC):
*G01R 27/26* (2006.01)  *G01R 29/22* (2006.01)
*G01R 31/28* (2006.01)  *B06B 1/02* (2006.01)
*B06B 1/06* (2006.01)  *H10N 30/80* (2023.01)

(52) Gemeinsame Patentklassifikation (CPC):
**G01R 29/22; B06B 1/0253; B06B 1/0644;**
**G01R 27/2605; G01R 31/2824; H10N 30/802;**
B06B 2201/72

(86) Internationale Anmeldenummer:
**PCT/EP2020/069972**

(87) Internationale Veröffentlichungsnummer:
**WO 2021/013649 (28.01.2021 Gazette 2021/04)**

(54) **VERFAHREN UND GENERATOR ZUR CHARAKTERISIERUNG EINES SCHWINGSYSTEMS**

METHOD AND GENERATOR FOR CHARACTERIZING AN OSCILLATORY SYSTEM

PROCÉDÉ ET GÉNÉRATEUR POUR LA CARACTÉRISATION D'UN SYSTÈME OSCILLANT

(84) Benannte Vertragsstaaten:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priorität: **23.07.2019   DE 102019119911**

(43) Veröffentlichungstag der Anmeldung:
**01.06.2022   Patentblatt 2022/22**

(73) Patentinhaber: **Herrmann Ultraschalltechnik**
**GmbH & Co. KG**
**76307 Karlsbad (DE)**

(72) Erfinder:
• **ERTZ, Gabriel**
**30453 Hannover (DE)**
• **TWIEFEL, Jens**
**30159 Hannover (DE)**
• **WALLASCHEK, Jörg**
**30161 Hannover (DE)**

(74) Vertreter: **WSL Patentanwälte Partnerschaft mbB**
**Kaiser-Friedrich-Ring 98**
**65185 Wiesbaden (DE)**

(56) Entgegenhaltungen:
DE-B3- 10 325 446    DE-B3-102014 012 917
DE-T2- 69 923 618

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die vorliegende Erfindung betrifft ein Verfahren zum Bestimmen von mindestens einer physikalischen Kenngröße eines elektro-mechanischen Schwingsystems, dass ein piezoelektrisches Element und zumindest ein weiteres, mit dem piezoelektrischen Element schwingungsgekoppeltes Element aufweist, wobei das piezoelektrische Element eine Elektrode und eine Gegenelektrode aufweist. Die vorliegende Erfindung betrifft zudem ein Verfahren zum Betreiben eines Ultraschallschwingsystems, bei dem das oben genannte Verfahren zum Bestimmen von mindestens einer physikalischen Kenngröße des Ultraschallschwingsystems zum Einsatz kommt. Darüber hinaus betrifft die vorliegende Erfindung auch einen Generator zum Bereitstellen einer Wechselspannung und zum Durchführen der zuvor genannten Verfahren.

Schwingsysteme mit piezoelektrischen Elementen kommen in zahlreichen Bereichen von Industrie und Forschung zum Einsatz. Als Beispiele seien die Verwendungen von piezoelektrischen Elementen bei Lautsprechern, Piezomotoren und Ultraschallschwingsystemen wie Ultraschallschweißvorrichtungen genannt. Die Vorteile der vorliegenden Erfindung ergeben sich in allen Bereichen, bei denen piezoelektrische Elemente als Bestandteil eines Schwingsystems verwendet werden und eine Kontrolle bzw. Regelung der Schwingung erwünscht ist. Im Folgenden werden die Merkmale und Vorteile der vorliegenden Erfindung schwerpunktmäßig am Beispiel von Ultraschallschwingsystemen, insbesondere anhand von industriellen Ultraschallschweißvorrichtungen erläutert.

Es ist erstrebenswert, dass reproduzierbare Ergebnisse bestimmter Qualität mit Schwingsystemen gefertigt werden können, seien es Schweißnähte bei Ultraschallschweißvorrichtungen, Schnitte bei Ultraschallschneidvorrichtungen, Töne bei Lautsprechern oder Abbildungen des Körperinneren bei Ultraschallgeräten in der Medizin.

Werden beispielsweise mit Ultraschallschwingsystemen kontinuierliche Prozesse durchgeführt, wie dies beim Verschweißen eines Materials mit der Sonotrode eines Ultraschallschweißgerätes der Fall ist, so hängt die Prozessqualität und Reproduzierbarkeit des Prozessergebnisses (der Schweißnaht) maßgeblich von dem zeitlichen Verhalten der Amplitude der dabei verwendeten mechanischen Schwingung ab. Bei einem Ultraschallschweißprozess ist es besonders erstrebenswert, dass die Amplitude der Schwingung für die Dauer des Prozesses oder auch für die gesamte Lebensdauer der Ultraschallschweißvorrichtung möglichst wenig variiert, sodass die mit der Ultraschallschweißvorrichtung gefertigten Schweißnähte homogen ausgebildet sind und eine reproduzierbare Qualität aufweisen.

Entscheidend für die Qualität der Schweißnaht ist auch die absolute Größe der Schwingungsamplitude. Ist die passende Schwingungsamplitude für einen Ultraschallschweißprozess einmal gefunden, wird diese für vergleichbare Prozesse bevorzugt immer wieder verwendet.

Die Kontrolle der Schwingungsamplitude bzw. des zeitlichen Verhaltens der Schwingungsamplitude trägt daher maßgeblich zur Kontrolle der Qualität und Reproduzierbarkeit einer mit einer Ultraschallschweißvorrichtung gefertigten Schweißnaht bzw. des entsprechenden Produkts bei.

Generell gilt für mechanische Schwingsysteme: Umso präziser die Amplitude eines Schwingsystems eingestellt, geregelt und kontrolliert werden kann, desto besser lässt sich auch die entsprechende Prozess- oder Produktqualität kontrollieren und folglich auch optimieren.

Bei einem piezoelektrischen Element, das wie bei einer Ultraschallschweißvorrichtung als Aktor verwendet wird, kann die Schwingungsamplitude des betreffenden Schwingsystems über eine am Aktor (Piezoaktor) angelegte Wechselspannung geregelt werden. Der Zusammenhang zwischen der verwendeten Wechselspannung $U(t)$, welche naturgemäß mit der Zeit $t$ variiert, und der Amplitude $X$ des Schwingsystems ergibt sich dabei wie folgt: Die Schwingungsamplitude $X$ verhält sich proportional zur Ladung $Q$ des Piezoaktors: $X \sim Q$. Die Ladung $Q$ ergibt sich wiederum aus der Integration über den messbaren Strom $I$, von dem der elektrische Anteil $I_{SW}$ des Stroms abgezogen wird, wobei sich der elektrische Anteil des Stroms aus dem Produkt der zeitlichen Ableitung $\dot{U}$ der anliegenden Spannung $U$ und der elektrischen Kapazität $C_{SW}$ des Schwingsystems ergibt. Folglich gilt: $Q = \int I - \dot{U} \, C_{SW}$. Die anliegende Wechselspannung $U$ ist bei diesem Abhängigkeitsverhältnis die einzige Regelgröße, die von außen eingestellt werden kann. Daher kann die Schwingungsamplitude $X$ prinzipiell über ein entsprechendes Anpassen der Wechselspannung $U$ eingestellt/geregelt werden.

Bei den bekannten Ultraschallschwingsystemen bzw. deren Verwendungen wird die Kapazität $C_{SW}$ des Schwingsystems als unveränderliche Konstante angenommen. Die elektrische Kapazität $C_{SW}$ wird dabei zumeist vor der Inbetriebnahme eines Ultraschallschwingsystems durch eine externe Messung oder auf der Basis vorbekannter Kapazitätswerte der elektrischen und piezoelektrischen Elemente des Ultraschallschwingsystems bestimmt und der so einmal bestimmte Wert zukünftigen Prozessen zugrunde gelegt.

Die elektrische Kapazität $C_{SW}$ eines Schwingsystems ergibt sich in der Regel aus der Summe der Kapazitäten der elektrischen und piezoelektrischen Elemente eines Schwingsystems. So setzt sich die elektrische Kapazität $C_{SW}$ bei einem Ultraschallschwingsystem häufig zumindest aus der Kapazität des piezoelektrischen Elements $C_P$ und der elektrischen Kapazität des verwendeten Kabels $C_{cabel}$, welches das piezoelektrische Element mit einer Wechselspannungsquelle verbindet, zusammen.

Die Kapazität eines Ultraschallschwingsystems kann sich allerdings im Laufe der Zeit ändern. Wird beispielsweise ein altes Kabel, welches das piezoelektrische Element mit einer Wechselspannungsquelle verbindet, durch ein neues Kabel ersetzt, kann dies einen Einfluss auf die Kapazität des Ultraschallschwingsystems haben, da sich die Kapazität des neuen Kabels von der Kapazität des alten Kabels häufig unterscheiden kann. Dies ist insbesondere dann sehr wahrscheinlich, wenn sich die Kabellänge von altem und neuem Kabel unterscheidet.

Neben Änderungen der elektrischen Kapazität $C_{SW}$ des Schwingsystems, die sich aufgrund einer derartigen Änderung des Systemaufbaus (Kabeltausch) ergeben können, verändert sich die Kapazität der elektrischen und piezoelektrischen Elemente des Schwingsystems, beispielsweise die Kapazität des piezoelektrischen Elements, auch intrinsisch. Diese Änderungen können dauerhaft sein aufgrund von Alterung, Verschleiß oder temporär aufgrund von äußeren Umgebungseinflüssen wie Temperaturschwankungen.

Wenn mit einer bekannten Ultraschallschwingvorrichtung aber nun eine Schwingung mit einer bestimmen Schwingungsamplitude erzeugt werden soll, wird für das Bestimmen der dazu benötigten Wechselspannung auf den hinterlegten Wert für die elektrische Kapazität $C_{SW}$ des Schwingsystems zurückgegriffen, ohne dass überprüft wird, ob der hinterlegte Wert noch dem tatsächlichen Wert entspricht. Daher kommt es häufig vor, dass eine Ultraschallschwingvorrichtung mit einer bestimmten Wechselspannung betrieben wird, um eine bestimmte Schwingungsamplitude zu erreichen, diese Schwingungsamplitude sich aber nicht einstellt.

Dies wird auch anhand des oben beschriebenen mathematischen Zusammenhangs deutlich: Wenn sich die elektrische Kapazität $C_{SW}$ ändert, während die angelegte Wechselspannung keine Änderung erfährt, kommt es aufgrund des oben beschriebenen Zusammenhangs zwischen Schwingungsamplitude $X$, Wechselspannung $U(t)$ und Kapazität $C_{SW}$ zu einer Veränderung der Ladung $Q$ und somit zu einer Veränderung der Schwingungsamplitude $X$.

Am Beispiel einer Ultraschallschweißvorrichtung lässt sich die Problematik kurz erläutern. Vor der Inbetriebnahme wird die elektrische Kapazität $C_{SW}$ einmalig durch externe Messungen bestimmt.

Nach der Inbetriebnahme wird für alle zukünftigen Prozesse davon ausgegangen, dass die eingangs bestimmte Kapazität $C_{SW}$ des betreffenden Ultraschallschwingsystems vorliegt. Folglich wird die am piezoelektrischen Element angelegte Wechselspannung so eingestellt, dass sich eine angestrebte Schwingungsamplitude einstellt, die unter der Annahme des eingangs bestimmten Wertes für die Kapazität $C_{SW}$ zu erwarten ist. Ändert sich nun allerdings die elektrische Kapazität der elektrischen und/oder piezoelektrischen Elemente des Ultraschallschwingsystems im Laufe der Verwendung der Ultraschallschweißvorrichtung, so ändert sich auch die Schwingungsamplitude. Die geänderte Schwingungsamplitude ist in der Regel für den betreffenden Prozess weniger gut geeignet als die eingangs eingestellte Schwingungsamplitude. Daher kommt es in der Regel auch zu einer Verringerung der Prozessqualität, d.h. zu einer Verringerung der Qualität der erzeugten Schweißnähte.

Aus der DE 103 25 446 B3 ist ein Verfahren zum Detektieren eines Fehlers bei einem Piezoaktor bekannt.

Aus der DE 699 23 618 T2 ist ein Verfahren zur Optimierung der Frequenz oder Amplitude eines Erregersignals zur Ansteuerung eines piezoelektrischen Antriebs mittels dynamischer Bestimmung seiner elektromechanischen Eigenschaften bekannt.

Vor diesem Hintergrund ist es Aufgabe der vorliegenden Erfindung, ein Verfahren und einen Generator zum Durchführen des Verfahrens bereitzustellen, mit denen ein Ausräumen oder zumindest Verringern der oben genannten Nachteile verwirklicht oder zumindest ermöglicht wird.

Diese Aufgabe wird zum einen durch ein Verfahren gemäß Anspruch 1 gelöst.

In einer Ausführungsform, die nicht Teil der Erfindung ist, aber nützlich zu deren Verständnis ist, handelt es sich um ein Verfahren zum Bestimmen von mindestens einer physikalischen Kenngröße eines elektromagnetischen Schwingsystems, dass ein piezoelektrisches Element und zumindest ein weiteres mit dem piezoelektrischen Element schwingungsgekoppeltes Element aufweist, wobei das piezoelektrische Element eine Elektrode und eine Gegenelektrode aufweist, mit den folgenden Schritten: (a) Anlegen einer elektrischen Wechselspannung zwischen Elektrode und Gegenelektrode für die Dauer eines Anregungsintervalls, um eine mechanische Schwingung des Schwingsystems oder eines Teilsystems anzuregen, sodass nach Ablauf des Anregungsintervalls das Schwingsystem oder das Teilsystem eine freie, nicht angeregte Schwingung ausführt; (b) nach Beenden des Anregens und während der freien, nicht angeregten Schwingung des Schwingsystems oder des Teilsystems: (i) Messen eines zeitlichen Verlaufs einer Spannung $U$, die zwischen der Elektrode und der Gegenelektrode anliegt, oder (ii) Kurzschließen von Elektrode und Gegenelektrode mit einer Leitung und Messen eines zeitlichen Verlaufs eines Stroms 7 durch die Leitung; und (c) Bestimmen der mindestens einen physikalischen Kenngröße aus dem in Schritt (b) (i) gemessenen zeitlichen Verlauf der Spannung $U$ oder dem in Schritt (b) (ii) gemessenen zeitlichen Verlauf des Stroms $I$.

Unter einer physikalischen Kenngröße des Schwingsystems sind insbesondere die Kapazität des Schwingsystems, die Kapazität eines piezoelektrischen Elements, die Resonanzfrequenz des Schwingsystems, die Antiresonanzfrequenz des Schwingsystems, die modale Ersatzkapazität des Schwingsystems, die modale Induktivität des Schwingsystems, der resonante Dämpfungskoeffizient des Schwingsystems, der antiresonante Dämpfungskoeffizient des Schwingsystems, der modale Ersatzwiderstand des Schwingsystems sowie weitere die Schwingung charakterisierende Parameter wir die Resonanz-Schwinggüte und die Antiresonanz-Schwinggüte zu verstehen.

Ein Schwingsystem kann im Sinne der vorliegenden Erfindung als Ganzes oder teilweise zu einer mechanischen Schwingung angeregt werden. Im letzteren Fall bilden die Elemente, die zu einer mechanischen Schwingung angeregt werden, ein Teilsystem des Schwingsystems. Beispielsweise können bei einem Ultraschallschwingsystem der Konverter und die Sonotrode über ein schwingungsdämpfendes Kabel mit einem Generator verbunden sein, sodass der Generator nicht in eine mechanische Schwingung versetzt wird. In diesem Fall bilden der Konverter, die Sonotrode und gegebenenfalls Teile des Kabels ein Teilsystem des Schwingungssystems, welches als Ganzes auch das gesamte Kabel und den Generator umfasst.

Das Anregungsintervall ist bevorzugt weniger als 100 Millisekunden und besonders bevorzugt weniger als 50 Millisekunden lang.

Durch das erfindungsgemäße Verfahren können physikalische Kenngrößen einschließlich der Kapazität $C_{SW}$ des Schwingsystems, welche die Schwingung charakterisieren, bestimmt werden, ohne dass ein Auseinandernehmen des Schwingsystems und Ausmessen der einzelnen Elemente des Schwingsystems notwendig ist. Das Verfahren ermöglicht es zudem, das Schwingsystem in Abhängigkeit von den bestimmten Kenngrößen zu optimieren.

Das erfindungsgemäße Verfahren ist ein Verfahren zum Bestimmen einer elektrischen Kapazität $C_{SW}$ des Schwingsystems, wobei in Schritt (b) der zeitliche Verlauf einer Spannung $U$, die zwischen der Elektrode und der Gegenelektrode des piezoelektrischen Elements anliegt, gemessen wird und in Schritt (c) die elektrische Kapazität $C_{SW}$ aus dem in Schritt (b) gemessenen zeitlichen Verlauf der Spannung $U$ bestimmt wird.

Diese Verfahren ermöglicht es, die elektrische Kapazität $C_{SW}$ eines bestehenden Schwingsystems deutlich schneller zu bestimmen als dies ohne die vorliegende Erfindung möglich gewesen wäre. Das Verfahren gemäß der hier diskutierten Ausführungsform benötigt nur ca. 150 ms bis 200 ms, um vollständig durchgeführt zu werden, wobei das Schwingsystem nicht auseinander gebaut bzw. strukturell verändert werden muss. Somit kann die Kapazität eines piezoelektrischen Elements äußerst schnell und effizient bestimmt und auch überwacht werden. Änderungen der elektrischen Kapazität $C_{SW}$ aufgrund von Alterung, Verschleiß oder Temperaturschwankungen können sofort detektiert werden und es kann innerhalb kürzester Zeit angemessen darauf reagiert werden.

Erfindungsgemäß erfolgt das Bestimmen einer elektrischen Kapazität $C_{SW}$ des Schwingsystems wie folgt: In Schritt (b) wird eine Messvorrichtung mit einer inneren Kapazität $C_{probe}$ und einem Innenwiderstand $R_{probe}$ zum Messen des zeitlichen Verlaufs der Spannung verwendet und Schritt (c) weist folgende Teilschritte auf: (aa) Bestimmen eines zeitlichen Verlaufs eines Gleichspannungsanteils $U_{DC}$ aus dem in Schritt (b) gemessenen zeitlichen Verlauf der Spannung $U$; (bb) Bestimmen eines charakteristischen Zeitintervalls $\tau$, innerhalb dessen ein in Schritt b) gemessener, anfänglicher Wert des Gleichspannungsanteils $U_{DC,0}$ auf den Wert $U_{DC,0}$/e abfällt; (cc) Berechnen der Kapazität $C_{SW}$ mit dem charakteristischen Zeitintervall $\tau$, bevorzugt mittels der Formel $C_{SW} = \tau/R_{probe} - C_{probe}$.

Der Buchstabe "e" steht in diesem Zusammenhang für die eulersche Zahl e = 2,178... . Zudem wird in der bevorzugten Ausführungsform des Schrittes (cc) angenommen, dass die Kapazität der Messvorrichtung $C_{probe}$ kein Bestandteil der elektrischen Kapazität des Schwingsystems ist. Dies ist insbesondere dann gerechtfertigt, wenn die Messvorrichtung nicht dauerhaft im Schwingsystem integriert ist. Falls die Messvorrichtung alternativ im Schwingsystem integriert ist, insbesondere auch während des Betriebes des Schwingsystems, umfasst die Kapazität des Schwingsystems in der Regel auch die Kapazität der Messvorrichtung $C_{probe}$, sodass sich die folgende, alternative Formel ergeben würde: $C_{SW} = \tau/R_{probe}$.

Der in Schritt (b) gemessene zeitliche Verlauf einer Spannung teilt sich auf in einen Gleichspannungsanteil $U_{DC}$ und in einen Wechselspannungsanteil $U_{AC}$. Beide Anteile treten überlagert auf. Besonders bevorzugt wird ein Hochpassfilter verwendet, um den Gleichspannungsanteil $U_{DC}$ zu separieren, sodass die Zeitkonstante $\tau$ präzise bestimmt werden kann.

Die Teilschritte (aa), (bb) und (cc) können auf vorteilhafte Weise alle automatisiert mittels entsprechend ausgebildeter Algorithmen ausgeführt werden, sodass durch die Messung der Spannung $U$ während einem freien, nicht angeregten Schwingen des Schwingsystems die Kapazität $C_{SW}$ berechnet werden kann. Das charakteristische Zeitintervall $\tau$ wird auch als Halbwertszeit des Spannungssignals beschrieben. Das erfindungsgemäße Verfahren macht sich bei dieser Ausführungsform die Erkenntnis zunutze, dass sich das piezoelektrische Element und die weiteren elektrischen Elemente des Schwingsystems physikalisch betrachtet ähnlich einem Plattenkondensator verhalten, der eine initiale Aufladung erfährt und sich anschließend wieder entlädt. Ebenso wie sich die Kapazität eines Plattenkondensators aus dessen Entladekurve bestimmen lässt, lässt sich demnach die Kapazität des Schwingsystems, das heißt der piezoelektrischen und elektrischen Elemente des Schwingsystems, aus dem in Schritt (b) (i) gemessen zeitlichen Verlauf bzw. Abfall der Spannung $U$ bestimmen. Dabei ist nur der Gleichspannungsanteil $U_{DC}$ der Spannung $U$ relevant.

Sofern die Kapazitäten der rein elektrischen Elemente des Schwingsystems bekannt sind, lässt sich die Kapazität $C_p$ eines verwendeten piezoelektrischen Elements aus der elektrischen Kapazität $C_{SW}$ bestimmen. Sofern keine Kapazitäten des Schwingsystems in Reihe geschaltet sind, ergibt sich $C_p$ aus der Subtraktion der Kapazitäten der übrigen elektrischen oder piezoelektrischen Elemente von $C_{SW}$.

In einer weiteren Ausführungsform erfolgt in Schritt (a) eine Anregung einer Frequenz 7 nahe oder gleich einer vorbekannten Resonanzfrequenz des Schwingsystems. Dies hat den Vorteil, dass bei dem in Schritt (b) gemessenen Spannungen oder Strömen das Signal-zu-Rauschen-Verhältnis besonders groß ist, sodass die zu bestimmenden physikalischen Kenngrößen mit einer höheren Genauigkeit bestimmt werden können.

Gemäß einer bevorzugten Ausführungsform sind bei einem der oben beschriebenen Verfahren, bei dem zumindest die elektrische Kapazität $C_{SW}$ des Schwingsystems bestimmt wird, folgende weitere Schritte vorgesehen: (d) Kurzschließen von Elektrode und Gegenelektrode mit einer Leitung und Messen eines zeitlichen Verlaufs eines Stromes 7 durch die Leitung, wobei Schritt (b) während eines ersten Messintervalls erfolgt und Schritt (d) während eines zweiten Messintervalls erfolgt, wobei das zweite Messintervall vorzugsweise nach dem ersten Messintervall erfolgt; (e) Bestimmen von mindestens einer weiteren physikalischen Kenngröße, vorzugsweise eines elektrischen Ersatzparameter des Schwingsystems, aus dem in Schritt (d) gemessenen zeitlichen Verlauf des Stroms $I$.

Bei dieser Ausführungsform werden sowohl der Verlauf der Spannung $U$ als auch der Verlauf des Stroms $I$ gemessen, d.h. in Schritt (b) wird die Alternative (i) und in Schritt (d) die Alternative (ii) durchgeführt. Bevorzugt wird zunächst die Spannung $U$ während eines ersten Messintervalls gemessen, danach die Elektrode mit der Gegenelektrode kurzgeschlossen und der Strom $I$ während eines zweiten Messintervalls gemessen.

Der Vorteil des Messens der Verläufe von Spannung $U$ und Strom 7 besteht darin, dass ein vollständiger Satz von Parametern bestimmt werden kann, der die Schwingung des Schwingsystems umfänglich charakterisiert. Somit lässt sich ein möglichst vollständiges Bild des Ist-Zustandes eines Schwingsystems mit einem piezoelektrischen Element anfertigen. Dies ermöglicht ein detailliertes Prozess-Monitoring und eine effiziente Prozess-Regelung entsprechender Schwingsysteme.

Gemäß weiterer Ausführungsformen sind ein oder mehrere der folgenden Schritte alleine oder in Kombination miteinander vorgesehen:

(f) Bestimmen einer Resonanzfrequenz $f_{res}$ des Schwingsystems aus dem in Schritt (d) bestimmten zeitlichen Verlauf des Stroms $I$;
(g) Bestimmen einer Antiresonanzfrequenz $f_{antires}$ des Schwingsystems aus dem in Schritt (b) bestimmten zeitlichen Verlaufs der Spannung $U$;

(h) Schritt (f), Schritt (g) und Berechnen der modalen Ersatzkapazität $C_m$ des Schwingsystems aus der

Kapazität $C_p$ mittels der Formel

$$C_m = C_p \left( \frac{f_{antires}^2}{f_{res}^2} - 1 \right);$$

(i) Schritt (h) und Berechnen der modalen Ersatzinduktivität $L_m$ des Schwingsystems aus der modalen Ersatzkapazität $C_m$, bevorzugt mittels der Formel

$$L_m = \frac{1}{4\pi^2 f_{res}^2 C_m};$$

(j) Bestimmen eines resonanten Dämpfungskoeffizienten $D_{res}$, der einen von der Zeit $t$ abhängigen Abfall einer Einhüllenden des zeitlichen Verlaufs des Stroms charakterisiert;
(k) Bestimmen eines antiresonanten Dämpfungskoeffizienten $D_{antires}$, der einen von der Zeit $t$ abhängigen Abfall einer Einhüllenden des zeitlichen Verlaufs der Spannung charakterisiert;
(l) Schritt (f), Schritt (i), Schritt (j) und Berechnen des modalen Ersatzwiderstandes $R_m$ mittels der Formel
$R_m = 4 \pi D_{res} L_m f_{res}$.

Der gemessene zeitliche Verlauf des Stromes verhält sich entsprechend zur mechanischen Schwingung des Schwingsystems. Die Resonanzfrequenz oder die Antiresonanzfrequenz kann in den Schritten (f) bzw. (g) daher durch das Ausmessen einer Periodendauer der Schwingung des Stromes $I$ bzw. der Spannung $U$ oder durch eine Fourier-Analyse des zeitlichen Verlaufs des Stromes bzw. der Spannung erfolgen.

Die vorliegende Erfindung betrifft auch ein Verfahren zum Betreiben eines Ultraschallschwingsystems. Kern des Verfahrens bleibt auch hierbei das oben beschriebene erfindungsgemäße Verfahren zum Bestimmen einer physikalischen Kenngröße eines Schwingsystems. Dieses Verfahren zum Bestimmen einer physikalischen Kenngröße wird in einem Verfahren zum Betreiben eines Ultraschallschwingsystems verwendet, wobei das Ultraschallschwingsystem zumindest einen Generator, einen Konverter und eine Sonotrode aufweist, wobei die Sonotrode zur Durchführung einer Ultraschallbearbeitung mit einem zu bearbeitenden Material in Kontakt gebracht wird, wobei der Konverter zumindest ein piezoelektrisches Element aufweist, und wobei der Generator eine Wechselspannung bereitstellt, die von dem piezoelektrischen Element des Konverters in eine mechanische Schwingung umgewandelt wird. Es wird in einer Bearbeitungspause, d.h. wenn die Sonotrode nicht mit dem zu bearbeitenden Material in Kontakt ist, ein Verfahren zum Bestimmen mindestens einer physikalischen Kenngröße gemäß einer der oben in Bezug auf dieses Verfahren beschriebenen Ausführungsformen durchgeführt.

Somit können auf besonders vorteilhafte Weise Bearbeitungspausen, die im Prozessbetrieb aus unterschiedlichen Gründen vorkommen, genutzt werden, um physikalische Kenngrößen, die bspw. eine Aussage über die Prozessqualität des Ultraschallschwingsystems treffen, zu bestimmen. Dies ermöglicht eine sehr effiziente Integration des erfindungsgemäßen Verfahrens zum Bestimmen von mindestens einer physikalischen Kenngröße eines Schwingsystems in den Prozess von Ultraschallschwingsystemen.

In einer bevorzugten Ausführungsform laufen in der Bearbeitungspause die folgenden Schritte ab: (A) Bestimmen der elektrischen Kapazität $C_{SW}$ des Ultraschallschwingsystems mit einem Verfahren zum Bestimmen einer elektrischen Kapazität $C_{SW}$ des Ultraschallschwingsystems gemäß einer der oben beschriebenen Ausführungsformen (B) Einstellen der Wechselspannung in Abhängigkeit von der in Schritt (A) bestimmten elektrischen Kapazität $C_{SW}$ des Ultraschallschwingsystems.

Dadurch wird ermöglicht, dass in Abhängigkeit von der bestimmten elektrischen Kapazität $C_{SW}$, eine Optimierung des Schwingprozesses vorgenommen wird. Mit Schritt (B) geht das Verfahren folglich über ein reines Monitoring von Schwingsystemen hinaus. Die in Schritt (B) zu erfolgende Reaktion auf das Bestimmen der elektrischen Kapazität $C_{SW}$ kann insbesondere automatisiert abgerufen werden. Dabei kann das Verfahren beispielsweise auf voreingestellte Einstellvorgänge zurückgreifen, die in Schritt (B) in Abhängigkeit von der bestimmten elektrischen Kapazität $C_{SW}$ ablaufen. Sollte die elektrischen Kapazität $C_{SW}$ beispielsweise unter bzw. oberhalb eines vordefinierten Unter- bzw. Obergrenze liegen, so kann die angelegte Wechselspannung beispielsweise abgeschaltet werden, um das Risiko einer Beschädigung des Ultraschallschwingsystems zu verringern.

Vor dem Hintergrund, dass sich die Kapazitäten der elektrischen und piezoelektrischen Elemente eines Ultraschallschwingsystems in Abhängigkeit von Zeit und Temperatur (Umgebungsparametern) ändern, stellt die hier diskutierte Ausführungsform eine temperatur- und alterungsadaptive Regelung der Schwingungsamplitude bereit.

Insbesondere kann innerhalb einer einzigen Bearbeitungspause eine vollständige Charakterisierung des Schwingsystems, d.h. eine Bestimmung der elektrische Kapazität $C_{SW}$, der Resonanzfrequenz $f_{res}$, der Antiresonanzfrequenz $f_{antires}$, der modalen Ersatzkapazität $C_m$, der modalen Ersatzinduktivität $L_m$, des resonanten Dämpfungskoeffizientens $D_{res}$, des antiresonanten Dämpfungskoeffizientens $D_{antires}$ und des modalen Ersatzwiderstandes $R_m$ des Schwingsystems, erfolgen. Diese vollständige Charakterisierung erfolgt dabei innerhalb eines Zeitintervalls von weniger als 300 ms, bevorzugt von weniger als 250 ms und besonders bevorzugt von weniger als 200 ms.

In einer besonders bevorzugten Ausführungsform weist der Schritt (B) folgende Teilschritte auf: (AA) Bestimmen der Amplitude $X$ der mechanischen Schwingung des Ultraschallschwingsystems mit der in Schritt (A) bestimmten elektrischen Kapazität $C_{SW}$ des Ultraschallschwingsystems; (BB) Vergleich der Amplitude $X$ mit einer Soll-Amplitude $X_0$; (CC) Einstellen der Frequenz und/oder der Amplitude der vom Generator bereitgestellten Wechselspannung, sodass sich eine Amplitude $X$ gleich der Soll-Amplitude $X_0$ einstellt.

Diese Ausführung des erfindungsgemäßen Verfahrens realisiert, dass die mechanische Schwingungsamplitude eines Ultraschallschwingsystems zeitlich möglichst konstant gehalten wird, um reproduzierbare Ergebnisse mit dem Schwingsystem zu produzieren. Dies wird mit der hier diskutierten Ausführungsform auf vorteilhafte Weise erreicht, da überprüft wird, ob die mechanische Schwingung die gewünschte Amplitude aufweist und sobald eine Abweichung festgestellt wird, diese Abweichung durch eine entsprechende Anpassung der angelegten Wechselspannung kompensiert wird, sodass sich der Sollwert der mechanischen Schwingungsamplitude wieder einstellt. Bevorzugt erfolgen in regelmäßigen Abständen wiederholt Bearbeitungspausen, während derer die Schritte (A) und (B) inklusive der Teilschritte (AA), (BB) und (CC) ablaufen.

Die der Erfindung zugrunde liegende Aufgabe wird zudem durch eine Vorrichtung gemäß Anspruch 11, nämlich einen Generator zum Bereitstellen einer Wechselspannung und mit Mitteln zum Durchführen eines Verfahrens gemäß einer der oben diskutierten Ausführungsformen, gelöst, wobei der Generator eine Wechselspannungsquelle, eine Potential-Leitung zwischen der Wechselspannungsquelle und einem Potentialanschluss und eine Masse-Leitung zwischen der Wechselspannungsquelle und einem Masseanschluss, aufweist, wobei die Masse-Leitung mit einer Erdung verbunden ist. Erfindungsgemäß verbindet eine Kurzschluss-Leitung die Potential-Leitung mit der Masse-Leitung, wobei der Generator eine erste Schaltvorrichtung aufweist, mit der die Potential-Leitung unterbrochen werden kann, und eine zweite Schaltvorrichtung aufweist, mit der die Kurzschluss-Leitung unterbrochen werden kann.

Der erfindungsgemäße Generator ist speziell für die Durchführung der oben diskutierten Verfahren ausgebildet. Um das Anregen der Schwingung gemäß Schritt (a) durchzuführen, ist die erste Schaltvorrichtung geschlossen und die zweite Schaltvorrichtung geöffnet, sodass sie Potential-Leitung nicht unterbrochen ist und die Kurzschluss-Leitung unterbrochen ist, sodass eine Wechselspannung am Potentialanschluss ausgegeben wird. Um Schritt (b) (i) durchzuführen, sind die erste und die zweite Schaltvorrichtung geöffnet, sodass keine Wechselspannung mehr am Potentialanschluss ausgegebene wird und kein Kurzschlussstrom fließen kann. Um Schritt (d) bzw. Alternative (b) (ii) durchzuführen, ist die erste Schaltvorrichtung geöffnet und die zweite Schaltvorrichtung geschlossen, sodass ein Kurzschlussstrom durch die Kurzschluss-Leitung, fließen kann.

Der erfindungsgemäße Generator kann universell eingesetzt werden, da er problemlos für unterschiedliche Schwingsysteme verwendet werden kann, um die Schwingungsamplitude zu regeln. In Kombination mit einem der erfindungsgemäßen Verfahren kalibriert sich der Generator selbst, sodass er in jedem Schwingsystem genau die Wechselspannung bereitstellt, die für die dort gewünschte Schwingungsamplitude erforderlich ist, ohne dass der Anwender manuell prozessspezifische Parameter hinterlegen muss.

Zusätzlich zum Generator werden zur Durchführung der Verfahren nur Mittel zum Messen der Spannung und des Stromes $I$ benötigt. Diese Mittel können beispielsweise durch ein Oszilloskop bereitgestellt werden. Besonders bevorzugt sind der Generator und die Mittel zum Messen der Spannung und des Stromes integral als Generator mit integriertem Oszilloskop ausgebildet.

Das erfindungsgemäße Verfahren gemäß der Ansprüche 1 bis 6 kann ausschließlich durch die Verwendung eines Generators, d.h. ohne die Verwendung externer Messgeräte, erfolgen.

Bevorzugt sind die erste und die zweite Schaltvorrichtung als Reed-Relais oder Halbleiterrelais ausgebildet. Solche Relais sorgen auf vorteilhafte Weise für ein sauberes und schnelles Umschalten, insbesondere für ein schnelles Trennen der Potential-Leitung zum Durchführen der Schritte (a) und (b) Schritt (a) und für ein sauberes Kurzschließen in Schritt (d) bzw. Alternative (b) (ii), während das Schwingsystem eine freie Schwingung ausführt.

Die erfindungsgemäßen Verfahren und der erfindungsgemäße Generator werden bevorzugt für Ultraschallschweißsysteme verwendet, besonders bevorzugt für Ultraschallschweißsysteme zum Schweißen von Kunstoffen oder Vliesstoffen.

Weitere Vorteile, Merkmale und Anwendungsmöglichkeiten der vorliegenden Erfindung werden deutlich anhand der folgenden Beschreibung einer bevorzugten Ausführungsform eines Verfahrens und einer bevorzugten Ausführungsform eines Generatoren und der zugehörigen Figuren.

Figur 1      zeigt ein vereinfachtes Ersatzschaubild eines ersten Ultraschallschwingsystems,

Figur 2      zeigt ein Schaltbild eines zweiten Ultraschallschwingsystems mit einem erfindungsgemäßen Generators in einem ersten Zustand,

Figur 3      zeigt ein Schaltbild des Ultraschallschwingsystems aus Figur 2 in einem zweiten Zustand,

Figur 4      zeigt ein Schaltbild des Ultraschallschwingsystems aus Figur 2 in einem dritten Zustand.

Figur 5      zeigt eine Kurve des gemessenen Verlaufs der Spannung des zweiten Ultraschallschwingsystems nach Anregung nahe der Resonanzfrequenz,

Figur 6      zeigt eine Kurve des gemessenen Verlaufs des Stromes des zweiten Ultraschallschwingsystems nach Anregung nahe der Resonanzfrequenz.

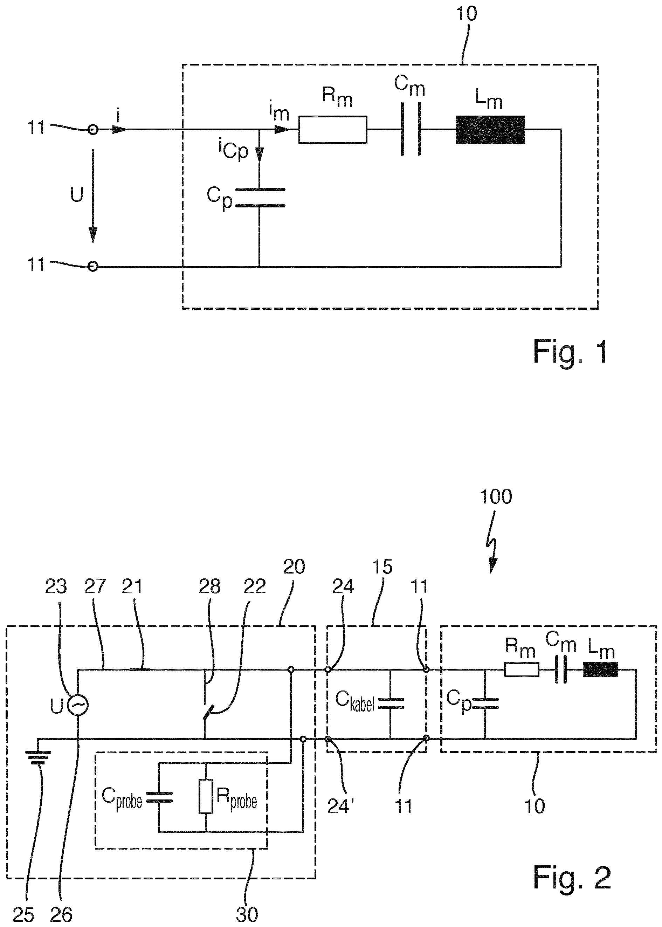

Das in Figur 1 gezeigte Ersatzschaubild stellt einen Fall dar, bei dem ein piezoelektrisches Element, nämlich ein Piezoaktor 10, mit der Kapazität $C_p$ nahe oder gleich seiner Resonanzfrequenz, d.h. bei einer Eigenmode, mit einer Wechselspannung $U$ zu einer Schwingung angeregt wird. Das Ersatzschaltbild zeigt folglich ein Schwingsystem, dass kein weiteres elektrisches oder piezoelektrisches Element außer dem Piezoaktor aufweist.

Unter dem Begriff "Ersatzschaubild" ist zu verstehen, dass sich mit dem Verhalten der im Ersatzschaubild gezeigten reinen elektrischen Schaltung, welche einen elektrischen Schwingkreis darstellt, das Verhalten des zugrundeliegenden piezoelektrischen Ultraschallschwingsystems beschreiben lässt, welches in der Realität neben elektrischen Elementen auch mechanische Elemente umfasst.

Über einen Signaleingang 11 wird im Ersatzschaubild der Figur 1 eine Spannung $U$ an dem Piezoaktor 10 angelegt. Die Schaltung des Piezoaktors 10 weist einerseits einen parallel geschalteten Kondensator mit der Kapazität $C_p$ auf, welcher die elektrische Domäne des Ersatzschaubildes darstellt. Unter der elektrischen Domäne ist der Bereich des Ersatzschaltbildes zu verstehen, der die elektrischen Eigenschaften eines piezoelektrischen Elements darstellt. Das piezo-elektrische Element hat in diesem Sinne tatsächlich die elektrischen Eigenschaften eines Kondensators. Bei dem Strom $i_{Cm}$, der in der elektrischen Domäne fließt, handelt es sich folglich um einen in der Realität in einem piezo-elektrischen Element fließenden elektrischen Strom.

Demgegenüber weist das Ersatzschaubild auch eine mechanische Domäne auf, die einen Ersatzwiderstand $R_M$, einen Kondensator mit der Ersatzkapazität $C_M$ und eine Spule mit der Ersatzinduktivität $L_M$ umfasst, wobei diese drei Elemente in Reihe geschaltet sind. Mit der mechanischen Domäne des Ersatzschaubildes werden die mechanischen Eigenschaften eines piezo-elektrischen Elements beschrieben. Die Elemente der mechanischen Domäne stellen keine tatsächlichen elektrischen Bauteile dar, sondern Ersatzelemente. Diese Ersatzelemente sind dabei so ausgebildet, dass sie einen elektrischen Schwingkreis bilden, bei dem die Ladungsamplitude sich genauso verhält wie die tatsächliche mechanische Amplitude des piezoelektrischen Elements. In diesem Sinne ist auch der Anteil des Stromes, der in der mechanischen Domäne fließt und der daher "mechanischer" Strom genannt wird, kein tatsächlich im piezo-elektrischen Element fließender Strom. Er repräsentiert somit die Umsetzung von elektrischer Energie in mechanische Energie innerhalb eines piezo-elektrischen Elementes.

Der elektrische Anteil des Stromes $I$ wird in der Figur 1 mit $i_{Cp}$ bezeichnet und der mechanische Anteil des Stromes $I$ wird in der Figur 1 mit $i_{Cm}$ bezeichnet. Gemessen wird der ebenfalls gezeigte gesamte Strom $I$. Die Amplitude der mechanischen Schwingung ergibt sich aus dem mechanischen Anteil $i_m$, sodass der elektrische Anteil $i_{Cp}$ bekannt sein muss, um $i_m$, damit die

Ladung *Q* und damit die Amplitude *X* aus einer Messung des gesamten Stroms *I* bestimmen zu können. Da der elektrische Anteil $i_{C_p}$ von der Kapazität des Schwingsystems, welche in Figur 1 mit der Kapazität des piezoelektrischen Elements identisch ist (in Figur 1: $C_p = C_{SW}$), abhängt, kann das erfindungsgemäße Verfahren in diesem Fall verwendet werden, um diese Kapazität $C_p$ zu bestimmen und somit die Bestimmbarkeit und Regelung der Schwingungsamplitude zu verbessern.

Mit welchen Messungen, Daten und Schritten eine Ausführungsform des erfindungsgemäßen Verfahrens dieses Ziel erreicht, ist in den Figuren 2 bis 6 gezeigt.

In den Figuren 2, 3 und 4 ist jeweils ein Schaltplan eines einen Generator aufweisenden Ultraschallschwingsystems 100 gezeigt, wobei die Figuren 2, 3 und 4 jeweils unterschiedliche Zustände der Schaltung innerhalb des Generators 20 zeigen. Das hier gezeigte Ultraschallschwingsystem 100 weist außerdem einen Piezoaktor 10 auf, welcher als Ersatzschaltbild entsprechend der Figur 1 dargestellt ist. Der Piezoaktor ist mit einem weiteren Element des Schwingsystems 100 (hier nicht gezeigt), beispielsweise einer Sonotrode, das hier nicht gezeigt ist, schwingungsgekoppelt. Der Piezoaktor 10 ist über ein Kabel 15 mit dem erfindungsgemäßen Generator 20 verbunden, wobei das Kabel eine Kapazität $C_{cable}$ aufweist. Der Generator 20 besteht aus einer Wechselspannungsquelle 23, die eine Wechselspannung *U* bereitstellt. Die Spannungsquelle 23 ist über eine Masse-Leitung 26 mit dem Masseanschluss 24' und eine Potential-Leitung 27 mit dem Potentialanschluss 24 des Generators verbunden. Die Potential-Leitung weist dabei eine erste Schaltvorrichtung 21 auf, mit der die Potential-Leitung unterbrochen werden kann, d. h. die elektrisch leitende Funktion der Potential-Leitung ausgeschaltet werden kann. Zudem ist eine Kurzschluss-Leitung 28 vorgesehen, welche die Potential-Leitung 27 und die Masse-Leitung 26 verbindet, wobei auch diese Leitung eine Schaltvorrichtung 22 aufweist, mit der die Kurzschluss-Leitung 28 unterbrochen werden kann, d. h. die elektrisch leitende Funktion der Kurzschluss-Leitung ausgeschaltet werden kann.

Der Signaleingang 11 ist derart mit der Elektrode und der Gegenelektrode des Piezoaktors 10 verbunden, dass eine am Signaleingang 11 angelegte Wechselspannung zwischen der Elektrode und der Gegenelektrode des Piezoaktors anliegt. Da der Signaleingang über ein Kabel mit dem Generator verbunden ist, können die Elektrode und die Gegenelektrode des Piezoaktors über die Schaltvorrichtung 22 kurzgeschlossen werden, indem die Potentialleitung und die Masseleitung verbunden werden.

Der Generator 20 weist zudem eine Messvorrichtung 30 in Form eines Oszilloskops auf, welches durch eine Parallelschaltung mit dem Potentialanschluss 24 und dem Masseanschluss 24' verbunden ist. Die Messvorrichtung 30 weist dabei wie im Schaltbild dargestellt eine innere Kapazität $C_{probe}$ und einen inneren Widerstand $R_{probe}$ auf.

Zum Durchführen des erfindungsgemäßen Verfahrens wird der in den Figuren 2, 3 und 4 gezeigte Generator 20 in unterschiedliche Zustände versetzt, indem die Schaltvorrichtungen 21 und 22 genutzt werden.

In Figur 2 ist zunächst nur die Potential-Leitung nicht unterbrochen, sodass die Wechselspannungsquelle elektrisch leitend mit dem Signalausgang verbunden ist, d.h. die Schaltvorrichtung 21 ist in einer geschlossenen Position. Die Schaltvorrichtung 22 ist hingegen offen, sodass es nicht zum Fließen eines Kurzschlussstroms zwischen Potential-Leitung und Masse-Leitung kommt. An dem Potentialanschluss 24 liegt somit die von der Spannungsquelle 23 bereitgestellte Wechselspannung an. Diese wird über das Kabel auf die Ultraschallschwingeinheit übertragen, sodass sie über den Signaleingang 11 am Piezoaktor anliegt, d.h. zwischen Elektrode und Gegenelektrode des Piezoaktors. Die Frequenz der angelegten Wechselspannung ist dabei bevorzugt so gewählt, dass sie einer Resonanzfrequenz des gezeigten Schwingsystems entspricht.

Durch die angelegte Wechselspannung wird der Piezoaktor in Schwingung versetzt. Figur 2 zeigt demnach den Zustand der Schaltung innerhalb eines Anregungsintervalls $[t_0,t_1]$ gemäß Schritt (a) des erfindungsgemäßen Verfahrens.

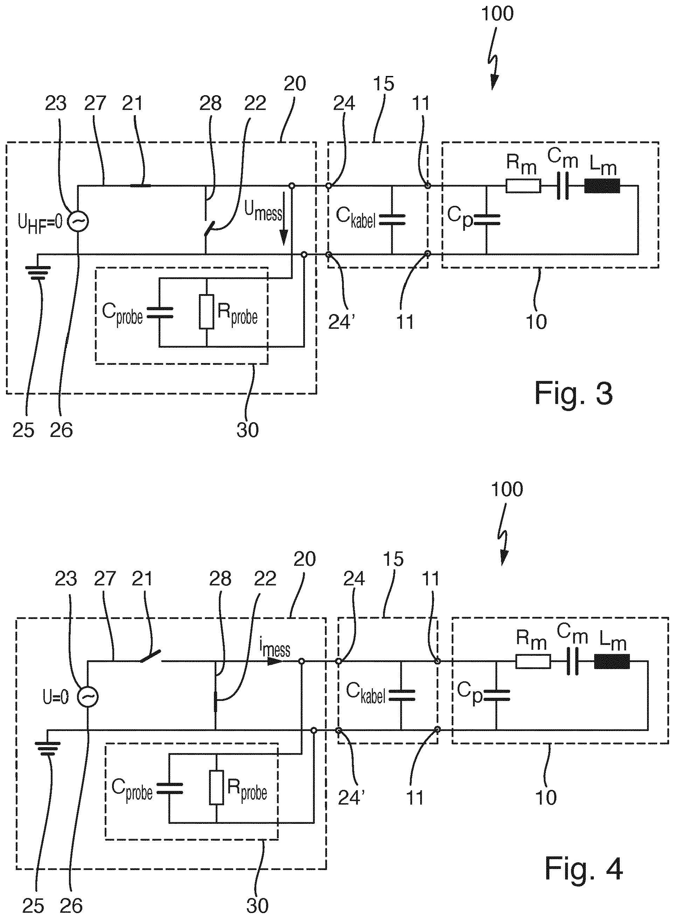

Um von Schritt (a) zu Schritt (b) des erfindungsgemäßen Verfahren zu gelangen, wird die Schaltvorrichtung 21 derart betätigt, dass die Verbindung zwischen Spannungsquelle und Potentialanschluss 24 - die Potentialleitung 27 - unterbrochen ist, sodass das Ultraschallschwingsystem 10 eine freie, nicht angelegte Schwingung ausführt, da keine Wechselspannung mehr zwischen Elektrode und Gegenelektrode des Piezoaktors anliegt. Der entsprechend Zustand der Schaltung mit einer nun geöffneten Schaltvorrichtung 21 ist in Figur 3 für die Alternative (b) (i) und in Figur 4 für die Alternative (b) (ii) gezeigt.

Ausgehend von einer Ausführungsform des erfindungsgemäßen Verfahrens, bei dem zunächst die Alternative (i) in Schritt (b) und danach Schritt (d), folglich die Alternative (ii) aus Schritt (b), durchgeführt wird, bleibt der Generator für ein erstes Messintervall $[t_1,t_2]$, in dem die Spannung mit der Messvorrichtung 30 gemäß Alternative (b) (i) gemessen wird, in dem in Figur 3 gezeigten Zustand mit den offenen Schaltvorrichtungen 21 und 22.

Um in einem zweiten Messintervall $[t_2,t_3]$ den Strom bzw. Kurzschlussstrom gemäß Schritt (d) zu messen, werden die Elektrode und die Gegenelektrode kurzgeschlossen, indem, wie in Figur 4 gezeigt, die Schaltvorrichtung 22 derart betätigt wird, dass sie eine Verbindung 28 zwischen der Potential-Leitung 27 und der Masse-Leitung 26 herstellt. Gemäß Schritt (d) wird der Kurzschlussstrom gemessen, während sich der erfindungsgemäße Generator 20 in dem in Figur 4 gezeigten Zustand befindet, wonach die Schaltvorrichtung 21 offen und die Schaltvorrichtung 22 geschlossen ist, und somit eine elektrisch leitende, direkte Verbindung zwischen Elektrode und Gegenelektrode besteht.

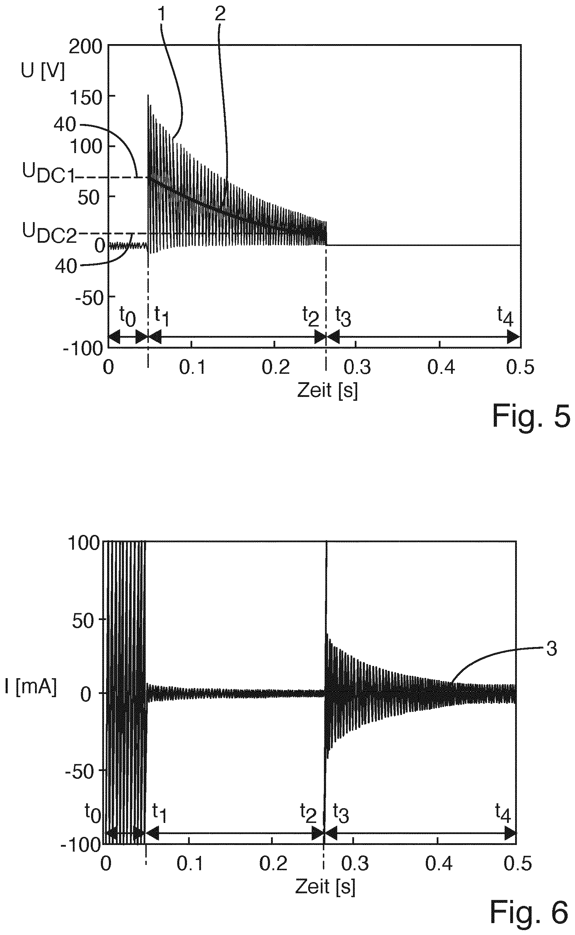

Die Figur 5 zeigt in einem zweidimensionalen Diagramm den zeitlichen Verlauf 1 der Spannung U und den zeitlichen Verlauf 2 des Gleichstromanteils der Spannung U im Anregungsintervall $[t_0,t_1]$, im ersten Messintervall $[t_1,t_2]$ und im zweiten Messintervall $[t_2,t_3]$. Für die hier dargestellte Messung wurde ein Ultraschallschwingsystem im Zeitintervall $[t_0,t_1]$ mit einer Frequenz nahe der Resonanzfrequenz des Ultraschallschwingsystems angeregt - durch Anlegen eines Wechselstroms (siehe Zustand der Schaltung aus Figur 2). Zum Zeitpunkt $t_1$ wurde der angelegte Wechselstrom ausgeschaltet, woraufhin ein Ausschwingvorgang des Ultraschallschwingsystems begann (siehe Zustand der Schaltung aus Figur 3). Im Zuge dieses Ausschwingvorgangs nahm ein initial vorhandener Gleichspannungsanteil $U_{DC,1}$ der Spannung zum Zeitpunkt $t_1$ exponentiell ab bis ein Gleichspannungsanteil $U_{DC,2}$ zum Zeitpunkt $t_2$ erreicht wurde. Der Verlauf 1 der Spannung $U$ insgesamt ergibt sich aus diesem exponentiellen Abfall des Gleichspannungsanteils $U_{DC}$ und dem überlagerten alternierenden Wechselspannungsanteil $U_{AC}$, dessen Amplitude ebenfalls im Verlauf des Messintervalls $[t_1, t_2]$ abnimmt. Zum Zeitpunkt $t_2$ werden Elektrode und Gegenelektrode durch die Kurzschluss-Leitung verbunden, d.h. kurzgeschlossen, sodass die Spannung zum Zeitpunkt $t_2$ abrupt auf null abfällt und für die Dauer des zweiten Messintervalls $[t_3,t_4]$ dort verbleibt, wobei hier der Fall $t_2=t_3$ gezeigt ist (siehe Zustand der Schaltung aus Figur 4).

Aus dem zeitlichen Abfall des Gleichspannungsanteils $U_{DC}$ lässt sich das charakteristische Zeitintervall t gemäß Schritt (c) (bb) bestimmen, beispielsweise mittels der Formel:

$$t = (t2 - t1)/ln(\frac{U_{DC,1}}{U_{DC,2}})$$

Die Figur 6 zeigt den zeitlichen Verlauf des Stroms $I$ für die gleiche Messung, für die der Verlauf der Spannung $U$ in Figur 2 gezeigt ist. So entspricht dem Zeitpunkt $t_3$ aus der Figur 5 der Zeitpunkt $t_2$ aus der Figur 2, zu dem Elektrode und Gegenelektrode kurzgeschlossen werden. In dem in Figur 6 gezeigten Messintervall $[t_3, t_4]$ wird ein durch den Kurzschluss getriggerter Kurzschlussstrom zwischen Elektrode und Gegenelektrode gemessen. Der Strom weist einen um die Nulllage alternierenden Verlauf, folglich einen reinen Wechselstromverlauf, auf. Dabei fällt die Amplitude des Wechselstroms exponentiell ab. Dies ist anhand einer gedachten Einhüllenden des Verlaufs des Wechselstroms zu erkennen. Aus diesem exponentiellen Abfall lässt sich durch einen Fit gemäß $e^{-D_{res}t}$ der resonante Dämpfungskoeffizient $D_{res}$ bestimmen. Entsprechend lässt sich anhand des in Figur 5 gezeigten Verlaufs der Spannung der antiresonante Dämpfungskoeffizient $D_{antires}$ aus dem Abfall einer Einhüllenden des Wechselspannungsanteils $U_{AC}$ bestimmen.

**Bezugszeichenliste**

| | |
|---|---|
| 1 | zeitlicher Verlauf der Spannung $U$ |
| 2 | zeitlicher Verlauf des Gleichspannungsanteils $U_{DC}$ |
| 3 | zeitlicher Verlauf des Stroms $I$ |
| 10 | piezoelektrisches Element / Piezoaktor |
| 11 | Signaleingang |
| 15 | Kabel |
| 20 | Generator |
| 21 | erste Schaltvorrichtung |
| 22 | zweite Schaltvorrichtung |
| 23 | Wechselspannungsquelle |
| 24 | Potentialanschluss |
| 24' | Masseanschluss |
| 25 | Masse |
| 26 | Masse-Leitung |
| 27 | Potential-Leitung |
| 28 | Kurzschluss-Leitung |
| 30 | Messvorrichtung/Oszilloskop |
| 40 | Hilfslinie |
| 100 | Ultraschallschwingsystem |
| $C_P$ | elektrische Kapazität des piezoelektrischen Elements |
| $R_m$ | Ersatzwiderstand des Ultraschallschwingsystems |
| $C_m$ | Ersatzkapazität des Ultraschallschwingsystems |
| $L_m$ | Ersatzinduktivität des Ultraschallschwingsystems |
| $C_{cable}$ | Elektrische Kapazität des Kabels |
| $C_{probe}$ | Innere Kapazität der Messvorrichtung (des Oszilloskops) |
| $R_{probe}$ | Innerer Widerstand der Messvorrichtung (des Oszilloskops) |
| U | Spannung |
| $U_{DC,1}$ | Gleichspannungsanteil zum Zeitpunkt $t_1$ |
| $U_{DC,2}$ | Gleichspannungsanteil zum Zeitpunkt $t_2$ |
| I | Strom |
| i | Strom (als Vektorgröße) |
| $i_m$ | mechanischer Stromanteil |
| $i_{Cp}$ | elektrischer Stromanteil |
| t | Zeit |
| s | Sekunden |
| V | Volt |

**Patentansprüche**

1. Verfahren zum Bestimmen einer elektrischen Kapazität $C_{SW}$ eines elektro-mechanischen Schwingsystems (100), das ein piezoelektrisches Element (10) und zumindest ein weiteres, mit dem piezoelektrischen Element (10) schwingungsgekoppeltes Element aufweist, wobei das piezoelektrische Element (10) eine Elektrode und eine Gegenelektrode aufweist,

mit den folgenden Schritten:

a) Anlegen einer elektrischen Wechselspannung zwischen Elektrode und Gegenelektrode für die Dauer eines Anregungsintervalls, um eine mechanische Schwingung des Schwingsystems oder eines Teilsystems des Schwingsystems anzuregen, sodass nach Ablauf des Anregungsintervalls das Schwingsystem oder das Teilsystem eine freie, nicht-angeregte Schwingung ausführt,

b) nach Beenden des Anregens und während der freien, nicht-angeregten Schwingung des Schwingsystems oder des Teilsystems: Messen eines zeitlichen Verlaufs einer Spannung $U$ (1), die zwischen der Elektrode und der Gegenelektrode anliegt, und

c) Bestimmen der elektrischen Kapazität $C_{SW}$ aus dem in Schritt b) gemessenen zeitlichen Verlauf der Spannung $U$ (1) , wobei in Schritt b) eine Messvorrichtung (30) mit einer inneren Kapazität $C_{probe}$ und einem Innenwiderstand $R_{probe}$ zum Messen des zeitlichen Verlaufs der Spannung $U$ (1) verwendet wird, und wobei Schritt c) folgende Teilschritte aufweist:

aa) Bestimmen eines zeitlichen Verlaufs eines Gleichspannungsanteils $U_{DC}$ (2) aus dem in Schritt b) gemessenen zeitlichen Verlauf der Spannung $U$ (1),

bb) Bestimmen eines charakteristischen Zeitintervalls $\tau$, innerhalb dessen ein in Schritt b) gemessener, anfänglicher Wert des Gleichspannungsanteils $U_{DC,0}$ auf den Wert $U_{DC,0}/e$ abgefallen ist,

cc) Berechnen der elektrischen Kapazität $C_{SW}$ mit dem charakteristischen Zeitintervall $\tau$.

2. Verfahren gemäß Anspruch 1, **dadurch gekennzeichnet, dass** in Schritt cc) die elektrische Kapazität $C_{SW}$ mittels der Formel

$$C_{SW} = \left(\frac{\tau}{R_{probe}}\right) - C_{probe}$$ berechnet wird.

3. Verfahren gemäß einem der vorstehenden Ansprüche, **dadurch gekennzeichnet, dass** in Schritt a) eine Anregung mit einer Frequenz $f$ nahe oder gleich einer vorbekannten Resonanzfrequenz des Schwingsystems (100) erfolgt.

4. Verfahren gemäß einem der vorstehenden Ansprüche, **dadurch gekennzeichnet, dass** folgender weiterer Schritt vorgesehen ist:

d) Kurzschließen von Elektrode und Gegenelektrode mit einer Leitung (28) und Messen eines zeitlichen Verlaufs eines Stroms $7$ (3) durch die Leitung,

wobei Schritt b) während eines ersten Messintervalls erfolgt und Schritt d) während eines zweiten Messintervalls erfolgt, wobei das zweite Messintervall vorzugsweise nach dem ersten Messintervall erfolgt,

e) Bestimmen von mindestens einer weiteren physikalischen Kenngröße, vorzugsweise eines elektrischen Ersatzparameters des Schwingsystems (100), aus dem in Schritt d) gemessenen zeitlichen Verlauf des Stroms $I$ (3).

5. Verfahren gemäß Anspruch 4, **dadurch gekennzeichnet, dass** eine oder mehrere der folgenden Schritte alleine oder in Kombination miteinander vorgesehen sind:

f) Bestimmen einer Resonanzfrequenz $f_{res}$ des Schwingsystems (100) aus dem in Schritt d) bestimmten zeitlichen Verlauf des Stroms $I$ (3),

g) Bestimmen einer Antiresonanzfrequenz $f_{antires}$ des Schwingsystems (100) aus dem in Schritt b) bestimmten zeitlichen Verlaufs der Spannung $U$ (1),

h) Schritt f), Schritt g) und Berechnen der modalen Ersatzkapazität $C_m$ des Schwingsystems (100) aus der Kapazität $C_{SW}$ mittels der Formel

$$C_m = C_{SW}\left(\frac{f_{antires}^2}{f_{res}^2} - 1\right),$$

i) Schritt h) und Berechnen der modalen Ersatzinduktivität $L_m$ des Schwingsystems (100) aus der modalen Ersatzkapazität $C_m$, bevorzugt mittels der Formel $L_m = \dfrac{1}{4\pi^2 f_{res}^2 C_m}$,

j) Bestimmen eines resonanten Dämpfungskoeffizienten $D_{res}$, der einen von der Zeit t abhängigen Abfall einer Einhüllenden des zeitlichen Verlaufs des Stroms $I$ (3) charakterisiert,

k) Bestimmen eines antiresonanten Dämpfungskoeffizienten $D_{antires}$, der einen von der Zeit t abhängigen Abfall einer Einhüllenden des zeitlichen Verlaufs der Spannung $U$ (1) charakterisiert,

l) Schritt f), Schritt i), Schritt j) und Berechnen des modalen Ersatzwiderstandes $R_m$ mittels der Formel $R_m = 4\,\pi\,D_{res}\,L_m\,f_{res}$.

6. Verfahren gemäß Anspruch 5, **dadurch gekenn-**

**zeichnet, dass** eine vollständige Charakterisierung des Schwingsystems (100) durch die Durchführung der Schritte f) bis j) erfolgt, vorzugsweise innerhalb eines Zeitintervalls von weniger als 300 ms, bevorzugt innerhalb eines Zeitintervalls von weniger als 250 ms und besonders bevorzugt innerhalb eines Zeitintervalls von weniger als 200 ms.

7. Verfahren zum Betreiben eines Ultraschallschwingsystems (100),

   wobei das Ultraschallschwingsystem (100) zumindest einen Generator (20), einen Konverter und eine Sonotrode aufweist, wobei die Sonotrode zur Durchführung einer Ultraschallbearbeitung mit einem zu bearbeitenden Material in Kontakt gebracht wird,
   wobei der Konverter zumindest ein piezoelektrisches Element (10) aufweist,
   und wobei der Generator (20) eine Wechselspannung bereitstellt, die von dem piezoelektrischen Element (10) des Konverters in eine mechanische Schwingung umgewandelt wird,
   **dadurch gekennzeichnet, dass**
   in einer Bearbeitungspause, in der die Sonotrode nicht mit dem zu bearbeitenden Material in Kontakt ist, ein Verfahren gemäß einem der Ansprüche 1 bis 6 durchgeführt wird.

8. Verfahren gemäß Anspruch 7, **dadurch gekennzeichnet, dass** zur Durchführung des Verfahrens gemäß einem der Ansprüche 1 bis 6 ausschließlich der Generator (20) verwendet wird.

9. Verfahren gemäß Anspruch 7 oder 8, **dadurch gekennzeichnet, dass** in der Bearbeitungspause folgende Schritte ablaufen:

   A) Bestimmen der elektrischen Kapazität $C_{SW}$ des Ultraschallschwingsystems (100) mit einem Verfahren gemäß einem der Ansprüche 1 bis 6,
   B) Einstellen der Wechselspannung in Abhängigkeit von der in Schritt A) bestimmten elektrischen Kapazität $C_{SW}$ des Ultraschallschwingsystems (100).

10. Verfahren gemäß Anspruch 9, **dadurch gekennzeichnet, dass** Schritt B) folgende Teilschritte aufweist:

    AA) Bestimmen der Amplitude X der mechanischen Schwingung des Ultraschallschwingsystems (100) mit der in Schritt A) bestimmten elektrischen Kapazität $C_{SW}$ des Ultraschallschwingsystems (100),
    BB) Vergleich der Amplitude X mit einer Soll-Amplitude $X_0$,
    CC) Einstellen der Frequenz und/oder der Amplitude der vom Generator (20) bereitgestellten Wechselspannung, sodass sich eine Amplitude X gleich der Soll-Amplitude $X_0$ einstellt.

11. Generator (20) zum Bereitstellen einer Wechselspannung und mit Mitteln zum Durchführen eines Verfahrens gemäß einem der Ansprüche 1 bis 10,

    mit einer Wechselspannungsquelle (23), einer Potential-Leitung (27) zwischen der Wechselspannungsquelle und einem Potentialanschluss (24), einer Masse-Leitung (26) zwischen der Wechselspannungsquelle (23) und einem Masseanschluss (24'), wobei die Masse-Leitung (26) mit einer Erdung verbunden ist,
    wobei eine Kurzschluss-Leitung (28) die Potentialleitung (27) mit der Masse-Leitung (26) verbindet,
    wobei der Generator (20) eine erste Schaltvorrichtung (21) aufweist, mit der die Potential-Leitung (27) unterbrochen werden kann,
    und eine zweite Schaltvorrichtung (22) aufweist, mit der die Kurzschlussleitung (28) unterbrochen werden kann.

12. Generator gemäß Anspruch 11, **dadurch gekennzeichnet, dass** die erste Schaltvorrichtung (21) und die zweite Schaltvorrichtung (22) Reed-Relais oder Halbleiterrelais sind.

## Claims

1. A method of determining an electrical capacitance $C_{SW}$ of an electro-mechanical oscillating system (100) comprising a piezoelectric element (10) and at least one further element oscillatingly coupled to the piezoelectric element (10), the piezoelectric element (10) comprising an electrode and a counter-electrode, comprising the following steps:

   a) applying an alternating electrical voltage between the electrode and the counter-electrode for the duration of an excitation interval to excite a mechanical vibration of the vibrating system or a subsystem of the vibrating system, such that after the excitation interval has elapsed, the vibrating system or the subsystem performs a free, non-excited vibration,
   b) after termination of the excitation and during the free, non-excited oscillation of the oscillating system or the subsystem:
   Measuring a variation over time of a voltage $U$ (1) applied between the electrode and the counter electrode, and
   c) determining the electrical capacitance $C_{sw}$, from the variation in time of the voltage U (1) measured in step b),

wherein in step b) a measuring device (30) having an internal capacitance $C_{probe}$ and an internal resistance $R_{probe}$ is used to measure the variation in time of the voltage $U$ (1) and

wherein step c) comprises the following substeps:

aa) determining a variation in time of a DC voltage component $U_{DC}$ (2) from the variation in time of the voltage $U$ (1) measured in step b),

bb) determining a characteristic time interval $\tau$, within which an initial value of the DC voltage component $U_{DC,0}$ measured in step b) has dropped to the value $U_{DC,0}/e$,

cc) calculating the electrical capacitance $C_{SW}$ with the characteristic time interval $\tau$.

2. The method according to claim 1, **characterized in that** in step cc) the electrical capacitance $C_{SW}$ is calculated by means of the formula

$$C_{SW} = \left(\frac{\tau}{R_{probe}}\right) - C_{probe}.$$

3. The method according to one of the preceding claims, **characterized in that** in step a) an excitation is performed with a frequency $f$ close to or equal to a previously known resonance frequency of the oscillating system (100).

4. The method according to one of the preceding claims, **characterized in that** the following further step is provided:

d) short-circuiting the electrode and the counter-electrode with a line (28) and measuring a variation in time of a current $I$ (3) through the line, wherein step b) takes place during a first measurement interval and step d) takes place during a second measurement interval, the second measurement interval preferably taking place after the first measurement interval,

e) determining at least one further physical parameter, preferably an electrical equivalent parameter of the oscillating system (100), from the variation in time of the current $I$ (3) measured in step d).

5. The method according to claim 4, **characterized in that** one or more of the following steps are provided alone or in combination with each other:

f) determining a resonant frequency $f_{res}$ of the oscillating system (100) from the variation in time of the current $I$ (3) determined in step d),

g) determining an anti-resonance frequency $f_{antires}$ of the oscillating system (100) from the variation in time of the voltage $U$ (1) determined in step b),

h) step f), step g) and calculating the modal equivalent capacitance $C_m$ of the oscillating system (100) from the capacitance $C_{SW}$ using the formula $$C_m = C_{SW}\left(\frac{f_{antires}^2}{f_{res}^2} - 1\right),$$

step h) and calculating the modal equivalent inductance $L_m$ of the oscillating system (100) from the modal equivalent capacitance $C_m$, preferably using the formula $$L_m = \frac{1}{4\pi^2 f_{res}^2 C_m},$$

j) determining a resonant damping coefficient $D_{res}$, characterizing a time t dependent decay of an envelope of the variation in time of the current $I$ (3),

k) determining an antiresonant damping coefficient $D_{antires}$, characterizing a drop of an envelope of the variation in time of the voltage $U$ (1) depending on the time t,

l) step f), step i), step j) and calculating the modal equivalent resistance $R_m$ of the formula $R_m = 4\pi D_{res} L_m f_{res}$.

6. The method according to claim 5, **characterized in that** a complete characterization of the oscillating system (100) is performed by carrying out steps f) to j), preferably within a time interval of less than 300 ms, preferably within a time interval of less than 250 ms and particularly preferably within a time interval of less than 200 ms.

7. The method of operating an ultrasonic oscillating system (100),

wherein the ultrasonic vibration system (100) comprises at least one generator (20), a converter and a sonotrode, wherein the sonotrode is brought into contact with a material to be processed in order to perform ultrasonic processing, wherein the converter comprises at least one piezoelectric element (10),

and wherein the generator (20) provides an alternating voltage which is converted into a mechanical vibration by the piezoelectric element (10) of the converter,

**characterized in that**

a method according to any one of claims 1 to 6 is carried out during a processing pause in which the sonotrode is not in contact with the material to be processed.

8. The method according to claim 7, **characterized in**

**that** for carrying out the method according to any one of claims 1 to 6, only the generator (20) is used.

9. The method according to claim 7 or 8, **characterized in that** the following steps are performed during the processing pause:

   A) determining the electrical capacitance $C_{SW}$ of the ultrasonic oscillation system (100) using a method according to any one of claims 1 to 6,
   B) adjusting the AC voltage as a function of the electrical capacitance $C_{SW}$ of the ultrasonic oscillating system (100) determined in step A).

10. The method according to claim 9, **characterized in that** step B) comprises the following substeps:

   AA) determining the amplitude X of the mechanical vibration of the ultrasonic vibration system (100) with the electrical capacitance $C_{SW}$ of the ultrasonic vibration system (100) determined in step A),
   BB) comparing the amplitude X with a target amplitude $X_0$,
   CC) adjusting the frequency and/or the amplitude of the AC voltage provided by the generator (20) so that an amplitude X equal to the target amplitude $X_0$ is established.

11. A generator (20) for providing an alternating voltage and having means for carrying out a method according to any one of claims 1 to 10,

   comprising an AC voltage source (23), a potential line (27) between the AC voltage source and a potential terminal (24), a ground line (26) between the AC voltage source (23) and a ground terminal (24'), wherein the ground line (26) is connected to a ground,
   wherein a short circuit line (28) connects the potential line (27) to the ground line (26), wherein the generator (20) comprises a first switching device (21) with which the potential line (27) can be interrupted
   and a second switching device (22) with which the short-circuit line (28) can be interrupted.

12. The generator according to claim 11, **characterized in that** the first switching device (21) and the second switching device (22) are reed relays or solid state relays.

**Revendications**

1. Procédé pour déterminer une capacité électrique $C_{SW}$ d'un système oscillant électromécanique (100) qui comprend un élément piézoélectrique (10) et au moins un autre élément attaché par oscillations à l'élément piézoélectrique (10), dans lequel l'élément piézoélectrique (10) comprend une électrode et une contre-électrode, avec les étapes suivantes :

   a) appliquer une tension alternative entre l'électrode et la contre-électrode pendant la durée d'un intervalle d'excitation afin d'exciter une oscillation mécanique du système oscillant ou d'un système partiel du système oscillant si bien que, après la fin de l'intervalle d'excitation, le système oscillant ou le système partiel effectue une oscillation libre non-excitée,
   b) après la fin de l'excitation et pendant l'oscillation libre non-excitée du système oscillant ou du système partiel :
   mesurer une évolution dans le temps d'une tension $U$ (1) qui est appliquée entre l'électrode et la contre-électrode, et
   c) déterminer la capacité électrique $Csw$ à partir de l'évolution dans le temps de la tension $U$ (1) mesurée à l'étape b),

   dans lequel, à l'étape b), un dispositif de mesure (30) avec une capacité interne $C_{probe}$ et une résistance interne $R_{probe}$ sont utilisées pour mesurer l'évolution dans le temps de la tension $U$ (1),
   et dans lequel l'étape c) comprend les étapes partielles :

   aa) déterminer une évolution dans le temps d'une composante de tension continue $U_{DC}$ (2) à partir de l'évolution dans le temps de la tension $U$ (1) mesurée à l'étape b),
   bb) déterminer un intervalle de temps caractéristique $\tau$ pendant lequel une valeur initiale de la composante de tension continue $U_{DC.0}$, mesurée à l'étape b), a baissée à la valeur $U_{DC.0}/e$,
   cc) calculer la capacité électrique $C_{SW}$ avec l'intervalle de temps caractéristique $\tau$.

2. Procédé selon la revendication 1, **caractérisé en ce que**, à l'étape cc), la capacité électrique $C_{SW}$ est calculée à l'aide de la formule $C_{SW} = (\tau / R_{Probe}) - C_{Probe}$.

3. Procédé selon l'une des revendications précédentes, **caractérisé en ce que**, à l'étape a), une excitation est mise en oeuvre à une fréquence f proche de ou égale à une fréquence de résonance préalablement connue du système oscillant (100).

4. Procédé selon l'une des revendications précédentes, **caractérisé en ce que** l'étape suivante supplémentaire est prévue :

d) court-circuiter l'électrode et la contre-électrode à l'aide d'un conducteur (28) et mesurer une évolution dans le temps d'un courant $I$ (3) passant par le conducteur, dans lequel l'étape b) est mise en oeuvre pendant un premier intervalle de mesure et l'étape d) est mise en oeuvre pendant un deuxième intervalle de mesure, dans lequel le deuxième intervalle de mesure est effectué de préférence après le premier intervalle de mesure,

e) déterminer au moins une autre valeur caractéristique physique, de préférence un paramètre de remplacement électrique du système oscillant (100), à partir de l'évolution dans le temps du courant $I$ (3) mesurée à l'étape d).

**5.** Procédé selon la revendication 4, **caractérisé en ce qu'**une ou plusieurs des étapes suivantes sont prévues isolément ou en combinaison les unes avec les autres :

f) déterminer une fréquence de résonance $f_{res}$ du système oscillant (100) à partir de l'évolution dans le temps du courant $I$ (3) déterminée à l'étape d),

g) déterminer une fréquence antirésonance $f_{antires}$ du système oscillant (100) à partir de l'évolution dans le temps de la tension $U$ (1) déterminée à l'étape b),

h) l'étape f), l'étape g) et le calcul de la capacité de remplacement modale $C_m$ du système oscillant (100) à partir de la capacité $C_{SW}$, à l'aide de la formule $C_m = C_{SW} ((f_{antires}^2 / f_{res}^2) - 1)$,

i) l'étape h) et le calcul de l'inductance de remplacement modale $L_m$ du système oscillant (100) à partir de la capacité de remplacement modale $C_m$, de préférence à l'aide de la formule $L_m = 1 / (4\pi^2 f_{res}^2 C_m)$,

j) déterminer un coefficient d'atténuation à résonance $D_{res}$ qui caractérise une décroissance en fonction du temps $t$ d'une enveloppe de l'évolution dans le temps du curant $I$ (3),

k) déterminer un coefficient d'atténuation à antirésonance $D_{antires}$ qui caractérise une décroissance en fonction du temps t d'une enveloppe de l'évolution dans le temps de la tension $U$ (1),

l) l'étape f), l'étape i), l'étape j) et le calcul de la résistance de remplacement modale $R_m$ à l'aide de la formule $R_m = 4 \pi D_{res} L_m f_{res}$.

**6.** Procédé selon la revendication 5, **caractérisé en ce qu'**une caractérisation complète du système oscillant (100) est effectuée par la mise en oeuvre des étapes f) à j), de préférence dans un intervalle de temps de moins de 300 ms, de manière préférée dans un intervalle de temps de moins de 250 ms, et de manière particulièrement préférée dans un intervalle de temps de moins de 200 ms.

**7.** Procédé pour faire fonctionner un système oscillant à ultra-sons (100),

dans lequel le système oscillant à ultra-sons (100) comprend au moins un générateur (20), un convertisseur et une sonotrode, dans lequel, pour effectuer un traitement par ultrasons, la sonotrode est mise en contact avec un matériau à traiter,

dans lequel le convertisseur comprend au moins un élément piézoélectrique (10)

et dans lequel le générateur (20) met à disposition une tension alternative qui est transformé, par l'élément piézoélectrique (10) du convertisseur, en une oscillation mécanique,

**caractérisé en ce que**,

pendant une pause de traitement pendant laquelle la sonotrode n'est pas en contact avec le matériau à traiter, un procédé selon l'une des revendications 1 à 6 est mis en oeuvre.

**8.** Procédé selon la revendication 7, **caractérisé en ce que**, pour la mise en oeuvre du procédé selon l'une des revendications 1 à 6, uniquement le générateur (20) est utilisé.

**9.** Procédé selon la revendication 7 ou 8, **caractérisé en ce que**, pendant la pause de traitement, les étapes suivantes se déroulent :

A) déterminer la capacité électrique $C_{SW}$ du système oscillant à ultrasons (100) à l'aide d'un procédé selon l'une des revendications 1 à 6,

B) ajuster la tension alternative en fonction de la capacité électrique $Csw$ du système oscillant à ultrasons (100) déterminée à l'étape A).

**10.** Procédé selon la revendication 9, **caractérisé en ce que** l'étape B) comprend les étapes partielles suivantes :

AA) déterminer l'amplitude X de l'oscillation mécanique du système oscillant à ultrasons (100) à l'aide de la capacité électrique $C_{SW}$ du système oscillant à ultrasons (100) déterminée à l'étape A),

BB) comparer l'amplitude X à une amplitude $X_0$ à atteindre,

CC) ajuster la fréquence et/ou l'amplitude de la tension alternative mise à disposition par le générateur (20), si bien qu'une amplitude X égale à l'amplitude $X_0$ à atteindre soit obtenue.

**11.** Générateur (20) pour mettre à disposition une tension alternative et avec des moyens pour mettre en oeuvre un procédé selon l'une des revendications 1 à 10,

avec une source de tension alternative (23), un conducteur de potentiel (27) entre la source de tension alternative et une borne de potentiel (24), un conducteur de masse (26) entre la source de tension alternative (23) et une borne de masse (24'), dans lequel le conducteur de masse (26) est relié à une terre,

dans lequel un conducteur de court-circuit (28) relie le conducteur de potentiel (27) au conducteur de masse (26),

dans lequel le générateur (20) comprend un premier dispositif de commutation (21) à l'aide duquel le conducteur de potentiel (27) peut être interrompu,

et comprend un deuxième dispositif de commutation (22) à l'aide duquel le conducteur de court-circuit (28) peut être interrompu.

12. Générateur selon la revendication 11, **caractérisé en ce que** le premier dispositif de commutation (21) et le deuxième dispositif de commutation (28) sont des relais reed ou des relais à semi-conducteur.

Fig. 1

Fig. 2

Fig. 3

Fig. 4

Fig. 5

Fig. 6

**IN DER BESCHREIBUNG AUFGEFÜHRTE DOKUMENTE**

**In der Beschreibung aufgeführte Patentdokumente**

- DE 10325446 B3
- DE 69923618 T2